# EUROPEAN PATENT SPECIFICATION

(11) **EP 1 952 290 B1**
(45) Date of publication and mention of the grant of the patent: **23.11.2011**
(21) Application number: 06809752.6
(22) Date of filing: 15.10.2006
(51) Int. Cl.: G11C 29/52, G06F 11/10

(54) **PROBABILISTIC ERROR CORRECTION IN MULTI-BIT-PER-CELL FLASH MEMORY**
PROBABILISTISCHE FEHLERKORREKTUR IN EINEM MEHRBIT-PRO-ZELLE-FLASH-SPEICHER
CORRECTION D'ERREUR PROBABILISTE DANS UNE MEMOIRE FLASH A BITS MULTIPLES PAR CELLULE

(30) Priority: 17.10.2005 US 726817 P; 26.01.2006 US 339571
(43) Date of publication of application: 06.08.2008
(73) Proprietor: Ramot at Tel-Aviv University Ltd., 61392 Tel Aviv (IL)
(72) Inventor: LITSYN, Simon, 54020 Givat Shmuel (IL); ALROD, Idan, 63504 Tel Aviv (IL); SHARON, Eran, 75493 Rishon Lezion (IL); MURIN, Mark, Kfar-saba 44233 (IL); LASSER, Menachem, 44864 Kohav Yair (IL)
(74) Representative: White, Duncan Rohan
(86) International application number: PCT/IL2006/001175
(87) International publication number: WO 2007/046084

(56) References cited:
- US-A- 5 475 693
- US-A- 6 029 264
- US-A- 6 069 821
- US-A1- 2002 048 202
- US-A1- 2004 225 947
- US-A1- 2005 213 393
- US-B1- 6 212 654
- US-B1- 6 625 236

## Description

### FIELD AND BACKGROUND OF THE INVENTION

The present invention relates to error correction of digital data and, more particularly, to a method of error correction for flash memory devices that store multiple bits per cell.

Flash memory devices have been known for many years. Typically, each cell within a flash memory stores one bit of information. Traditionally, the way to store a bit has been by supporting two states of the cell - one state represents a logical "0" and the other state represents a logical "1". In a flash memory cell the two states are implemented by having a floating gate above the cell's channel (the area connecting the source and drain elements of the cell's transistor), and having two valid states for the amount of charge stored within this floating gate. Typically, one state is with zero charge in the floating gate and is the initial unwritten state of the cell after being erased (commonly defined to represent the "1" state) and another state is with some amount of negative charge in the floating gate (commonly defined to represent the "0" state). Having negative charge in the gate causes the threshold voltage of the cell's transistor (*i. e.* the voltage that has to be applied to the transistor's control gate in order to cause the transistor to conduct) to increase. Now it is possible to read the stored bit by checking the threshold voltage of the cell: if the threshold voltage is in the higher state then the bit value is "0" and if the threshold voltage is in the lower state then the bit value is "1". Actually there is no need to accurately read the cell's threshold voltage. All that is needed is to correctly identify in which of the two states the cell is currently located. For that purpose it is enough to make a comparison against a reference voltage value that is in the middle between the two states, and thus to determine if the cell's threshold voltage is below or above this reference value.

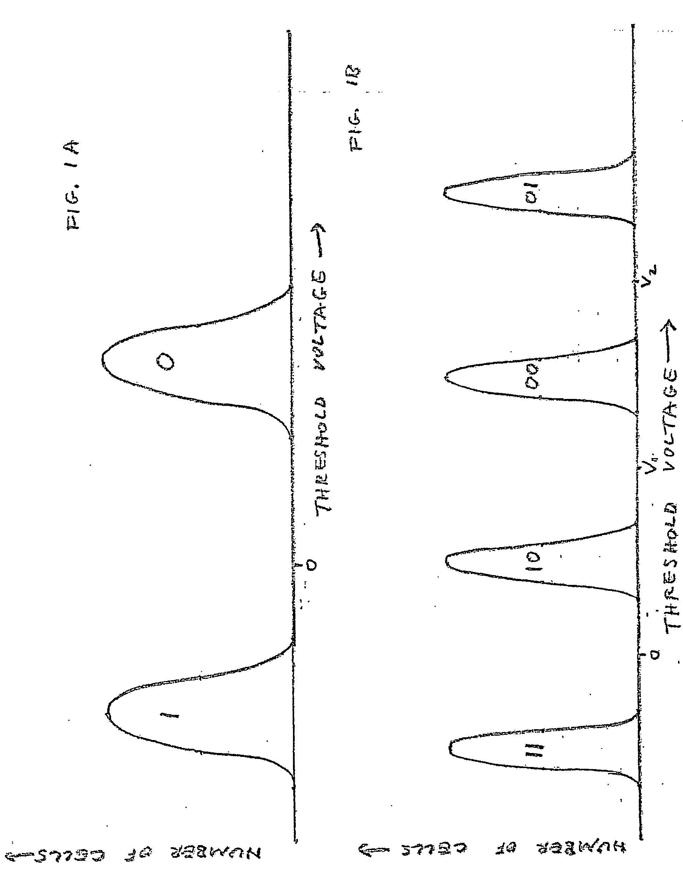

Figure 1A shows graphically how this works. Specifically, Figure 1A shows the distribution of the threshold voltages of a large population of cells. Because the cells in a flash memory are not exactly identical in their characteristics and behavior (due, for example, to small variations in impurities concentrations or to defects in the silicon structure), applying the same programming operation to all the cells does not cause all of the cells to have exactly the same threshold voltage. (Note that, for historical reasons, writing data to a flash memory is commonly referred to as "programming" the flash memory.) Instead, the threshold voltage is distributed similar to the way shown in Figure 1A. Cells storing a value of "1" typically have a negative threshold voltage, such that most of the cells have a threshold voltage close to the value shown by the left peak of Figure 1A, with some smaller numbers of cells having lower or higher threshold voltages. Similarly cells storing a value of "0" typically have a positive threshold voltage, such that most of the cells have a threshold voltage close to the value shown by the right peak of Figure 1A, with some smaller numbers of cells having lower or higher threshold voltages.

In recent years a new kind of flash memory has appeared on the market, using a technique conventionally called "Multi Level Cells" or MLC for short. (This nomenclature is misleading, because the previous type of flash cells also have more than one level: they have two levels, as described above. Therefore, the two kinds of flash cells are referred to herein as "Single Bit Cells" (SBC) and "Multi-Bit Cells" (MBC).) The improvement brought by the MBC flash is the storing of two or more bits in each cell. In order for a single cell to store two bits of information the cell must be able to be in one of four different states. As the cell's "state" is represented by its threshold voltage, it is clear that a 2-bit MBC cell should support four different valid ranges for its threshold voltage. Figure 1B shows the threshold voltage distribution for a typical 2-bit MBC cell. As expected, Figure 1B has four peaks, each corresponding to one state. As for the SBC case, each state is actually a range and not a single number. When reading the cell's contents, all that must be guaranteed is that the range that the cell's threshold voltage is in is correctly identified. For a prior art example of an MBC flash memory see US Patent No. 5,434,825 to Harari.

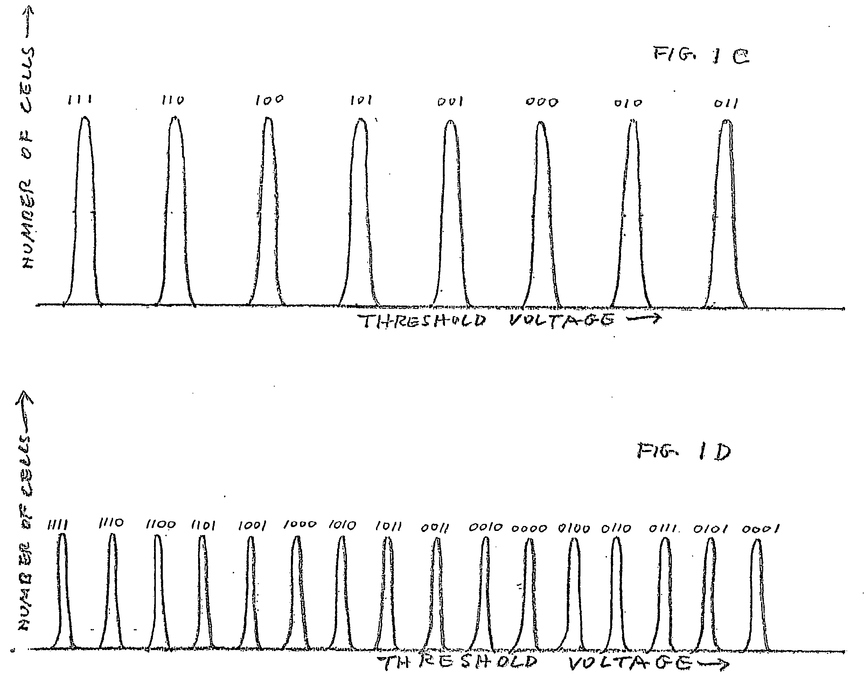

Similarly, in order for a single cell to store three bits of information the cell must be able to be in one of eight different states. So a 3-bit MBC cell should support eight different valid ranges for its threshold voltage. Figure 1C shows the threshold voltage distribution for a typical 3-bit MBC cell. As expected, Figure 1C has eight peaks, each corresponding to one state. Figure 1D shows the threshold voltage distribution for a 4-bit MBC cell, for which sixteen states, represented by sixteen threshold voltage ranges, are required.

When encoding two bits in an MBC cell via the four states, it is common to have the left-most state in Figure 1B (typically having a negative threshold voltage) represent the case of both bits having a value of "1". (In the discussion below the following notation is used - the two bits of a cell are called the "lower bit" and the "upper bit". An explicit value_ of the bits is written in the form ["upper bit" "lower bit"], with the lower bit value on the right. So the case of the lower bit being "0" and the upper bit being "1" is written as "10". One must understand that the selection of this terminology and notation is arbitrary, and other names and encodings are possible). Using this notation, the left-most state represents the case of "11". The other three states are typically assigned by the following order from left to right: "10", "00", "01". One can see an example of an implementation of an MBC NAND flash memory using this encoding in US Patent No. 6,522,580 to Chen, which patent is incorporated by reference for all purposes as if fully set forth herein. See in particular Figure 8 of the Chen patent. US Patent No. 6,643,188 to Tanaka also shows a similar implementation of an MBC NAND flash memory, but see Figure 7 there for a different assignment of the states to bit encodings: "11", "10", "01", "00". The Chen encoding is the one illustrated in Figure 1B.

We extend the above terminology and notation to the cases of more than two bits per cell, as follows. The left-most unwritten state represents "all ones" ("1... 1"), the string "1...10" represents the case of only the lowest bit of the cell being written to "0", and the string "01... 1" represents the case of only the most upper bit of the cell being written to "0".

When reading an MBC cell's content, the range that the cell's threshold voltage is in must be identified correctly; only in this case this cannot always be achieved by comparing to only one reference voltage. Instead, several comparisons may be necessary. For example, in the case illustrated in Figure 1B, to read the lower bit, the cell's threshold voltage first is compared to a reference comparison voltage V₁ and then, depending on the outcome of the comparison, to either a zero reference comparison voltage or a reference comparison voltage V₂. Alternatively, the lower bit is read by unconditionally comparing the threshold voltage to both a zero reference voltage and a reference comparison voltage V₂, again requiring two comparisons. For more than two bits per cell, even more comparisons might be required.

The bits of a single MBC cell may all belong to the same flash page, or they may be assigned to different pages so that, for example in a 4-bit cell, the lowest bit is in page 0, the next bit is in page 1, the next bit in page 2, and the highest bit is in page 3.- (A page is the smallest portion of data that can be separately written in a flash memory).

Lasser, US Patent Application Ser. No. 11/035,807, deals with methods of encoding bits in flash memory cells storing multiple bits per cell. Lasser, US Patent Application Ser. No. 11/061,634, and Murin, US Patent Application Ser. No. 11/078,478, deal with the implications of those methods of bits encoding on the question of error distribution across different logical pages of multi-bit flash cells. Specifically, Lasser '634 teaches a method for achieving even distribution of errors across different logical pages, as seen by the user of the data and as dealt with by the Error Correction Code (ECC) circuitry, using a logical-to-physical mapping of bit encodings; and Murin teaches a method for achieving even distribution of errors across different logical pages, as seen by the user of the data and as dealt with by the ECC circuitry, using interleaving of logical pages between physical bit pages.

Both Lasser '634 and Murin address the same goal: reducing the error rate for which the ECC circuitry should be designed. In the example presented in both applications a group of 15,000 4-bit MBC flash memory cells is used for storing 4 logical pages of data, of 15,000 bits each. The assumed cell error rate is 1 in 1,000. The resulting optimal number of bit errors is 15, and therefore the optimal average bit errors in a logical page is 3.75. The example shows that unless the proposed innovations are used, a specific logical page might end up with a much higher bit error rate - 6 bit errors in the example shown. This means that even though the overall average of bit errors across all bits stored in the cells is relatively low (15 in 60,000, or 1 in 4,000), unless special measures are taken the ECC circuitry dealing with correcting errors in a logical page must be designed to handle a relatively high average bit error rate (in that example - 6 in 15,000, or 1 in 2,500).

A recent US patent application by the inventors of the present application and entitled "METHOD OF ERROR CORRECTION IN MBC FLASH MEMORY" (herein "Litsyn et al.") discloses a different approach to the same goal. Instead of dealing with each logical page separately for the purpose of error correction, Litsyn et al. deal with all logical pages sharing the same group of cells at the same time, treating all bits of all those multiple logical pages as one ECC codeword. This causes the average bit error rate which the ECC circuitry has to cope with to be lower - only 1 in 4,000 in the example above.

In most ECC implementations all bits are treated the same and no bits are considered more reliable or less reliable than the average. However, as is evident from the above, when reading multiple logical pages from a group of MBC flash memory cells, the bits stored in different bit pages have different error probabilities. Some of the prior art methods for averaging errors distribution discussed above (Lasser '634, Murin) succeed in causing all logical pages to have the same number of bit errors on average, but different individual bits still have different reliabilities.

Information about bit error rates of individual bits in a codeword that is to be error corrected is very useful for an error correction module. We shall demonstrate this using a very simplified example. Assume a group of four bits protected against a single error by a parity bit, such that if an error is detected the ECC selects one of the bits to be flipped and provides this as the correction result. If all five bits in the codeword (four data bits and one parity bit) are equally likely to be in error, then the decision as to which bit to flip upon detecting an error can only be made at random. This leads to only 20% correct decisions. But if one of the bits is known to be six times less reliable than any of the other four bits in the codeword, then selecting that bit to be flipped upon detecting an error results in 60% correct decisions. While this example is extremely simplified and in real-world ECC implementations the methods of calculation and decision taking are much more complicated, it does serve the purpose of demonstrating the usefulness of reliability data for individual bits for improving the performance of error correction schemes.

There are prior art systems in which extra reliability information affects the way ECC circuitry handles different bits. See for example US patent application 10/867,645 to Ban et al. filed june 16, 2004 and entitled "METHODS OF INCREASING THE RELIABILITY OF A FLASH MEMORY". In Ban et al. the data stored in a flash cell are read using a higher resolution than is required for separating the state of a cell into its possible values. For example, if a cell is written into one of 16 states (i.e. the cell stores 4 bits), then the cell is read as if it had 5 bits. This is called using "fractional levels" by Ban et al. but others use different terms such as "soft bits". Others also use more than one bit of extra reading to provide even a higher resolution. The extra bits provided by that high resolution reading are used by the ECC module for estimating reliability of other "true" data bits, as they provide evidence regarding the exact state of a cell compared to the borders separating its state (as it was actually read) from the neighboring states. A cell located near a border is more likely to be in error than a cell located in the middle of the band and far away from the borders. There are also prior art communication systems that utilize this approach, where sometimes many extra high resolution bits are used for improving the error correction performance of a channel.

US2004/0225947 discloses a multi-bit cell memory wherein the data words are stored together with error correction information, and wherein the data words are recovered from the read bits by decoding the read bits in accordance with respective probabilities based on quality data statistics of the bit positions of the memory.

US2005/0213393 discloses a method for error correction in multi-bit cells which takes account of the fact that not all erroneous state transitions between the bit states in a flash cell are equally probable.

In all these prior art systems, the extra reliability information is information additional to information inherent in just the stored bits themselves. Such ECC would be simplified if it could be based only on what is inherent in the stored bits themselves. For example, ECC based on extra reliability information could be implemented without reading the cells of a MBC flash memory with more resolution than is needed to read the bits stored in the cells.

### SUMMARY OF THE INVENTION

The invention is defined by claim 1.

Preferably, in the method of the present invention, the probabilities depend on the significances of the relevant bits. The "significance" of a bit stored in a MBC cell is the position of the bit in the binary number that is stored in the MBC cell. For example, a MBC cell that stores four bits stores a binary number, between 0 and 15, that has four bits: a least significant bit, a next-to-least significant bit, a next-to-most significant bit and a most significant bit. Alternatively, the probabilities depend on the bit pages of the relevant bits. It is common practice in a MBC flash memory for all the bits of a common significance to be grouped in the same logical bit page(s), in which case these two dependencies of the probabilities are equivalent.

The scope of the present invention also includes a controller, for a MBC memory, that recovers data stored in the memory using one of the methods of the present invention, a memory device that includes a MBC memory and a controller of the present invention, and a computer-readable storage medium having embodied thereon computer-readable code for managing a memory according to one of the methods of the present invention.

### BRIEF DESCRIPTION OF THE DRAWINGS

The invention is herein described, by way of example only, with reference to the accompanying drawings, wherein:
FIGs. 1A-1D show threshold voltage distributions in a one-bit flash cell, a two-bit flash cell, a three-bit flash cell and a four-bit flash cell;
FIG. 2 is a high-level block diagram of a flash memory device of the present invention; and
FIG. 3 is a high-level partial block diagram of a data storage system of the present invention..

### DESCRIPTION OF THE PREFERRED EMBODIMENTS

The present invention is of a method of error correction, for a multi-bit-per-cell memory, that takes advantage of knowledge of probabilities of the various bits stored in each cell of being in error.

The principles and operation of error correction according to the present invention may be better understood with reference to the drawings and the accompanying description.

The first two methods of the present invention are improved methods for correcting errors in data read from an MBC flash memory device, utilizing reliability information derived from the locations in which individual bits are stored within the cells of the device (e.g., in the case of a MBC flash memory device in which the bits of each cell belong to different pages, in which bit pages the individual bits are stored). The third method of the present invention is an improved method for correcting errors in data read from an MBC flash memory device, using reliability information derived from correlation between different bits sharing a common cell. The proposed methods are applicable to cases in which the ECC codeword used in the correction process contains multiple bits that reside in a shared cell. This is always the case when the methods of Litsyn et al. are employed for correcting errors in data read from MBC flash devices.

In the first two methods of the present invention, advantage is taken of the fact that the physical storage location of each bit is known, and consequently its expected error rate is also known (note that the terms "error rate of a bit" and "reliability of a bit" are used here as two opposite aspects of the same feature, and therefore are used interchangeably for referring to the same characteristic). Consequently, the ECC module takes advantage of this information by assigning each bit an *initial priori* probability of error that serves as a starting point to the ECC calculations and decisions. The invention is not limited to any specific ECC scheme or algorithm - there are many ECC algorithms known in the prior art that can take advantage of such initial starting point and provide a better error correction in terms of probability of success, time to converge or other factors of success.

In particular, the first two methods of the present invention are intended for use with "soft" decoding algorithms. Such algorithms are described e.g. in George C. Clark, Jr. and J. Bibb Cain, Error Correction Coding for Digital Communications (Springer, 1951), in S. Lin and D. J. Costello, Error Control Coding: Fundamentals and Applications (Prentice-Hall, 1983) and in Branka Vucetic and Jinhong Yuan, Turbo Codes: Principles and Applications (Kluwer, 2000). Although these references are directed at the use of soft ECC algorithms in communications, it will be clear to those skilled in the art how to adapt those algorithms to error correction in multi-bit-per-cell memories.

These methods differ from the prior art methods mentioned above in which extra information is derived from reading the cells with higher resolution. In the present invention the different reliability values are determined prior to reading the data and are not dependent on the actual values of the data read. This is not the case in the above prior art methods. In other words, the present invention is capable of using *a-priori* probabilities of error for individual bit positions, even if such probabilities cannot be derived from the actual data, while prior art systems are dependent upon the ability to extract such probabilities from the actual data. The present invention makes use of probabilities that can be supplied, for example, by the vendor of the flash. One advantage of *this a priori* probability is that the present invention is simpler to implement than the prior art methods. Unlike those methods, the present invention does not need to extract and manipulate additional bits on top of the stored bits.

For example, consider the four-bit-per-cell bit ordering {15,14,12,13,9,8,10,11,3,2,0,4,6,7,5,1} that is discussed in Lasser '634 and in Murin. (This is the bit ordering that is illustrated in Figure 1D.) As shown in those patent applications, the lowest-order bit is six times as likely as the highest-order bit to be in error, the second-lowest-order bit is five times as likely as the highest-order bit to be in error, and the second-highest-order bit is three times as likely as the highest-order bit to be in error. In a group of 15,000 four-bit-per-cell MBC cells that is used to store four logical pages of data, with an assumed cell error rate of 1 in 1,000, the lowest-order bit of each cell has an *a priori* error probability of 6/15,000 = 2/5,000, the second-lowest-order bit of each cell has an *a priori* error probability of 5/15,000 = 1/3,000, the second-highest-order bit of each cell has an *a priori* error probability of 3/15,000 = 1/5,000 and the highest-order bit of each cell has an *a priori* error probability of 1/15,000.

In this example, the *a priori* error probabilities of the bits are functions only of the significances of the bits. All the bits in the same bit page have the same *a prior* probability of being in error. More generally, it is possible for some bits of a bit page to have different *a priori* error probabilities than other bits of the same bit page.

In the third method of the present invention, advantage is taken of the fact that in addition to reliability information derived from a bit's location in the physical page bits of MBC cells, there is another source of information that may be utilized by an ECC module. Contrary to the case where each bit of an ECC codeword originates from a different cell, where there is no correlation between the errors of different bits, in the case there are in the codeword multiple bits originating from the same cell (as is the case in the method of Litsyn et al.), we may deduce from the value of one bit about values of other bits in the same cell. As not all erroneous state transitions in a flash cell are equally probable, deductions can be made from one bit to another.

Consider, for example, the four-bit-per-cell bit ordering {15,14,12,13,9,8,10,11,3,2,0,4,6,7,5,1}. Suppose that the decoding of the cells is done sequential, from the most significant bit to the least significant bit. Suppose that the three most significant bits of a cell have been read as "100" and have been corrected to "101" by the ECC algorithm. The only way that this could have happened with a shift of only one threshold voltage range is if the cell was written as 10 (binary 1010) and read as 8 (binary 1000). The alternatives are:
The cell was written as 10 (binary_1010) and read as 9 (binary 10001), a shift of two threshold voltage ranges.
The cell was written as 11 (binary 1011) and read as 8 (binary 1000), a shift of two threshold voltage ranges.
The cell was written as 11 (binary 1011) and read as 9 (binary 1001), a shift of three threshold voltage ranges.

This implies that the odds of the least significant bit being "0" are much higher than the odds of the least significant bit being "1".

This method also differs from the prior art methods mentioned above in which extra information is derived from reading the cells with higher resolution. In the present invention the only bits that are input into the ECC module are the data bits and their corresponding parity bits. No other data-dependent inputs (in contrast to predetermined non-data-dependent inputs) is provided to the ECC module for performing its correction process. This is not the case in the above prior art methods, where extra bits of higher precision are generated from the cells and provided to the ECC module as auxiliary inputs.

The scope of the present invention also includes the more general case in which only some but not all of the bits in the codeword are assigned initial probabilities that are different from the average. It also includes the more general case in which the correlation effects between bits sharing cells are only taken into account for some but not all of the cells.

So far, the present invention has been presented in the context of error correction schemes that are "systematic". As noted above, in systematic error correction coding, the original data bits are preserved by the encoding process and can be identified within the bits stored. In other words, the error correction mechanism takes the original data bits, adds to them some parity bits, and stores both data bits and parity bits. Later, when reading the stored bits, both the data bits and the parity bits are read, and the parity bits enable the correction of errors in the read data bits, thus generating the original data bits.

However, the present invention is equally applicable to non-systematic error correction codes. As noted above, in such codes the original data bits are not preserved and are not stored. Instead, the encoding process transforms the original data bits into a larger group of bits that are the bits actually stored. When reading the stored protected data bits the original data bits are re-generated, even if there are errors in the protected data bits. The defining characteristic of non-systematic codes is that there is no direct correspondence between a specific original data bit and a specific stored bit. An original data bit is "scattered" in multiple stored bits, and only the combination of those multiple stored bits tells the value of the original bit..

The scope of the present invention includes methods for reading data bits from an MBC flash memory device, as described above. The scope of the present invention also includes a flash memory controller that reads from an array of MBC flash memory cells according to the above methods. The scope of the invention also includes a flash memory device that combines an array of MBC flash memory cells with a flash memory controller that reads from the array according to the above methods.

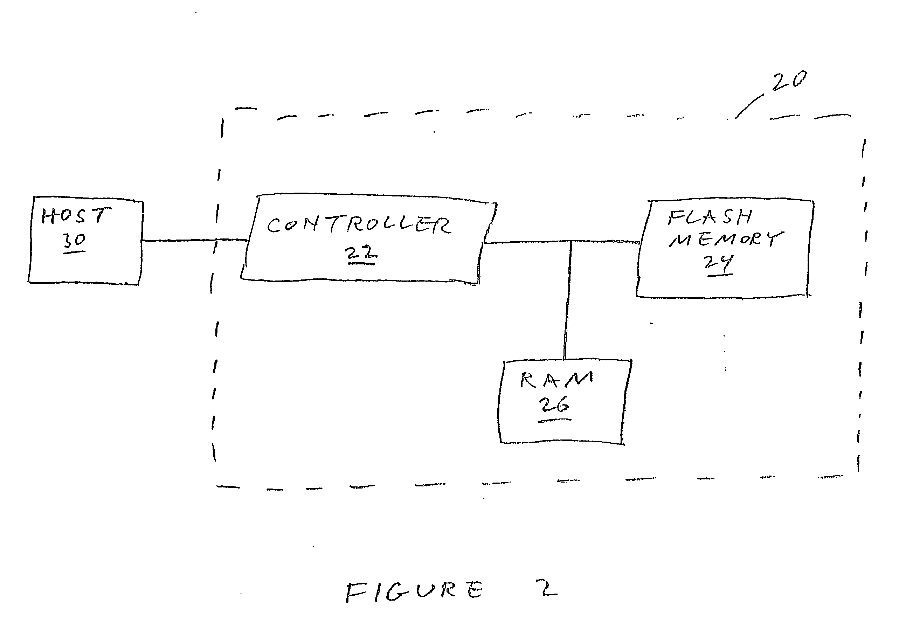

Referring again to the drawings, Figure 2 is a high-level block diagram of a flash memory device **20** of the present invention, coupled to a host **30**. Figure 2 is adapted from Figure 1 of Ban, US Patent No. 5,404,485.

Flash memory device **20** includes a flash memory **24,** a controller **22** and a random access memory (RAM) **26**. Controller **22**, that corresponds to "flash control **14"** of US 5,404,485, manages flash memory **24,** with the help of RAM 26, as described in US 5,404,485. Flash memory **24** encodes data, two or more bits per cell of flash memory **24,** as described in US 6,522,580 or in US 6,643,188. When reading the data, controller **22** applies error correction as described above.

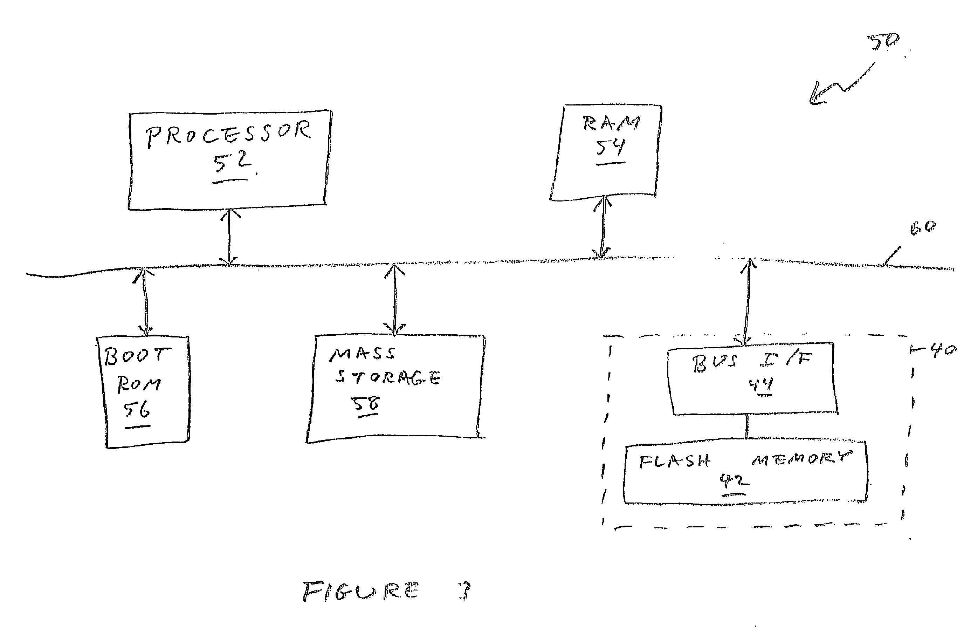

Figure 3 is a high-level partial block diagram of an alternative data storage system **50** of the present invention. Data storage system **50** includes a processor **52** and four memory devices: a RAM **54**, a boot ROM **56**, a mass storage device (hard disk) **58** and a flash memory device **40,** all communicating via a common bus **60.** Like flash memory device **20,** flash memory device **40** includes a flash memory **42.** Unlike flash memory device **20,** flash memory device **40** lacks its own controller and RAM. Instead, processor **52** emulates **controller 22** by executing a software driver that implements the methodology of US 5,404,485 in the manner e.g. of the TrueFFS™ driver of M-Systems Flash Disk Pioneers Ltd. of Kfar Saba, Israel. Flash memory **42** encodes data, two or more bits per cell of flash memory **42,** as described in US 6,522,580 or in US 6,643,188. When reading the data, processor **52** applies error correction as described above.. Flash memory device **40** also includes a bus interface **44** to enable processor **52** to communicate with flash memory **42.**

The code of the software driver that processor **52** executes to manage flash memory **42** is stored in mass storage device **58** and is transferred to RAM **54** for execution. Mass storage device **58** thus is an example of a computer-readable code storage medium in which is embedded computer readable code for managing flash memory **42** according to the principles of the present invention.

While the invention has been described with respect to a limited number of embodiments, it will be appreciated that many variations, modifications and other applications of the invention may be made.

## Claims

1. A method of reading a plurality of data bits that are stored in a memory that includes a plurality of multi-bit cells, the storing being effected by either:
a) computing a plurality of parity bits that correspond to the data bits and then storing the data bits and the parity bits as stored bits in the cells of the memory, or:
b) computing a plurality of protected bits that correspond to the data bits and then storing the protected bits as stored bits in the cells of the memory,
with a respective plurality of the stored bits being stored in each of the cells, the method comprising the steps or
reading the cells, thereby obtaining, for each cell, a respective plurality of read bits; and
recovering the data bits from the read bits, wherein said recovering is effected by steps including decoding said read bits in accordance with respective probabilities, of at least two of said read bits being erroneous,
that are based on one or both of:
(i) respective significances of said read bits, and
(ii) respective bit pages of said read bits,
wherein at least one said probability is different from at least one other said probability.

2. The method of claim 1, wherein said decoding includes soft decoding.

3. The method of claim 1, wherein said respective probabilities are based only on one or both of
i) respective significances of said read bits, and
ii) respective bit pages of said read bits.

4. A controller, for a memory that includes a plurality of multi-bit cells, that reads data stored in the memory using the method of claim 1.

5. A memory device comprising:
(a) a memory that includes a plurality of multi-bit cells; and
(b) the controller of claim 4 for controlling said memory.

6. A carrier medium carrying computer readable code for controlling a computer to carry out the method of claim 1, 2 or 3.

## Patentansprüche

1. Verfahren zum Auslesen einer Vielzahl von Datenbits, die in einem Speicher gespeichert sind, der eine Vielzahl von Mehrbitzellen aufweist, wobei das Speichern bewirkt wird durch entweder:
a) Berechnen einer Vielzahl von Paritätsbits, die den Datenbits entsprechen, und dann Speichern der Datenbits und der Paritätsbits als gespeicherte Bits in den Zellen des Speichers, oder:
b) Berechnen einer Vielzahl von geschützten Bits, die den Datenbits entsprechen, und dann Speichern der geschützten Bits als gespeicherte Bits in den Zellen des Speichers,
wobei eine jeweilige Vielzahl der gespeicherten Bits in jeder der Zellen gespeichert wird, wobei das Verfahren die folgenden Schritte umfasst:
Auslesen der Zellen, dadurch Erlangen einer jeweiligen Vielzahl von gelesenen Bits für jede Zelle; und
Wiederherstellen der Datenbits aus den gelesenen Bits, wobei das Wiederherstellen durch Schritte bewirkt wird, die folgendes aufweisen: Decodieren der gelesenen Bits gemäß jeweiligen Wahrscheinlichkeiten dafür, dass mindestens zwei der gelesenen Bits fehlerhaft sind, die auf einem oder beidem von folgenden beruhen:
(i) jeweilige Signifikanzen der gelesenen Bits, und
(ii) jeweilige Bitseiten der gelesenen Bits,
wobei mindestens eine besagte Wahrscheinlichkeit sich von mindestens einer anderen besagten Wahrscheinlichkeit unterscheidet.

2. Verfahren nach Anspruch 1, wobei das Decodieren weiches Decodieren aufweist.

3. Verfahren nach Anspruch 1, wobei die jeweiligen Wahrscheinlichkeiten nur auf einem oder beidem von folgendem beruhen:
(i) jeweilige Signifikanzen der gelesenen Bits, und
(ii) jeweilige Bitseiten der gelesenen Bits.

4. Steuerungseinrichtung für einen Speicher, der eine Vielzahl von Mehrbitzellen aufweist, die in dem Speicher gespeicherte Daten unter Verwendung des Verfahrens nach Anspruch 1 ausliest.

5. Speichereinrichtung, umfassend:
(a) einen Speicher, der eine Vielzahl von Mehrbitzellen aufweist; und
(b) die Steuerungseinrichtung nach Anspruch 4 zum Steuern des Speichers.

6. Trägermedium, das computerlesbaren Code zum Steuern eines Computers, damit er das Verfahren nach Anspruch 1, 2 oder 3 ausführt, trägt.

## Revendications

1. Procédé de lecture d'une pluralité de bits de données qui sont mémorisés dans une mémoire qui comprend une pluralité de cellules multibits, la mémorisation étant effectuée soit :
a) en calculant une pluralité de bits de parité qui correspondent aux bits de données et en mémorisant ensuite les bits de données et les bits de parité en tant que bits mémorisés dans les cellules de la mémoire, soit :
b) en calculant une pluralité de bits protégés qui correspondent aux bits de données et en mémorisant ensuite les bits protégés en tant que bits mémorisés dans les cellules de la mémoire,
une pluralité respective des bits mémorisés étant mémorisés dans chacune des cellules, le procédé comprenant les étapes consistant à :
lire les cellules, obtenant de ce fait, pour chaque cellule, une pluralité respective de bits lus ; et
récupérer les bits de données parmi les bits lus, dans lequel ladite récupération est effectuée par des étapes comprenant le décodage desdits bits lus conformément à des probabilités respectives, qu'au moins deux desdits bits lus soient erronés, qui sont basées sur un des éléments suivants ou les deux :
(i) les importances respectives desdits bits lus, et
(ii) les pages de bits respectives desdits bits lus,
dans lequel au moins une dite probabilité est différente d'au moins une autre dite probabilité.

2. Procédé selon la revendication 1, dans lequel ledit décodage comprend un décodage pondéré.

3. Procédé selon la revendication 1, dans lequel lesdites probabilités respectives ne sont basées que sur l'un des éléments suivants ou les deux :
(i) les importances respectives desdits bits lus, et
(ii) les pages de bits respectives desdits bits lus.

4. Contrôleur, pour une mémoire qui comprend une pluralité de cellules multibits, qui lit des données mémorisées dans la mémoire en utilisant le procédé de la revendication 1.

5. Dispositif de mémoire comprenant :
(a) une mémoire qui comprend une pluralité de cellules multibits ; et
(b) le contrôleur de la revendication pour commander ladite mémoire.

6. Support supportant un code pouvant être lu par un ordinateur pour commander un ordinateur pour effectuer le procédé des revendications 1, 2 ou 3.
